# FASCICULE DE BREVET EUROPEEN

(11) **EP 3 872 830 B1**
(45) Date de publication et mention de la délivrance du brevet: **03.04.2024**
(21) Numéro de dépôt: 21159172.2
(22) Date de dépôt: 25.02.2021
(51) Int. Cl.: H01H 37/76, H01C 7/12

(54) **APPAREIL ÉLECTRIQUE CONTRE LES SURTENSIONS TRANSITOIRES ET UN DISPOSITIF DE VARISTANCES À DÉTECTION D'EMBALLEMENT THERMIQUE**
FÜR TRANSIENTE ÜBERSPANNUNGEN UND BLITZSCHUTZ GEEIGNETER ÜBERSPANNUNGSABLEITER UND VORRICHTUNG MIT VARISTOREN MIT DETEKTION EINER THERMISCHEN ÜBERLAST
TRANSIENT OVERVOLTAGE AND LIGHTNING PROTECTION APPARATUS AND DEVICE COMPRISING VARISTORS WITH DETECTION OF THERMAL OVERLOAD

(30) Priorité: 27.02.2020 FR 2001941
(43) Date de publication de la demande: 01.09.2021
(73) Titulaire: Legrand France, 87000 Limoges (FR); Legrand SNC, 87000 Limoges (FR)
(72) Inventeur: RASSE, Gaëtan, 87700 BEYNAC (FR)
(74) Mandataire: Cabinet Camus Lebkiri

(56) Documents cités:
- EP-A1- 2 765 590
- WO-A1-2016/110359
- DE-A1-102010 008 537

## Description

### DOMAINE TECHNIQUE DE L'INVENTION

Le domaine technique de l'invention est celui des parasurtenseurs tels que les parafoudres à varistances, comprenant des appareils électriques contre les perturbations électriques, notamment contre les surtensions transitoires dues notamment à un impact de foudre.

La présente invention concerne un appareil électrique contre les surtensions transitoires dans lequel est installé un dispositif de varistances à détection d'emballement thermique comprenant des varistances, et en particulier l'invention concerne la déconnexion des varistances due à un emballement thermique.

### ARRIERE-PLAN TECHNOLOGIQUE DE L'INVENTION

Il est connu d'assurer la protection d'une installation électrique contre les surtensions à l'aide d'appareil électrique contre les surtensions transitoires dans lequel est monté au moins un composant de protection contre les surtensions, en particulier une ou plusieurs varistances. Les varistances permettent d'écrêter les surtensions à partir d'une valeur connue, et permettent ainsi de limiter la propagation de la surtension sur le réseau électrique. Dans les cas les plus fréquents, une varistance est branchée entre une phase et le neutre de l'installation électrique. Dans le cas d'une tension nominale, la résistance de la varistance est suffisamment importante pour ne pas avoir de courant ou un faible courant de fuite généralement quelques centaines de micro-ampères, et en cas de surtension, la résistance de la varistance chute permettant la décharge vers la terre et ainsi protéger l'installation électrique.

Cependant, il est nécessaire de déconnecter la varistance du réseau électrique lorsqu'elle arrive en fin de vie. En effet, la varistance se détériore à chaque surtension en ayant son impédance qui diminue. Le courant de fuite qui traverse la varistance augmente ce qui se traduit par une augmentation de la production de la chaleur par perte joules qui est fonction de cette impédance. Plus l'impédance est faible, plus le courant de fuite est important et donc produit un échauffement pouvant entraîner une surchauffe, voir un départ de feu dans une tableau électrique comprenant l'appareil électrique contre les surtensions transitoires comprenant la varistance. Dans ce cas, on parle d'emballement thermique de la varistance.

Lors de la fin de vie de la varistance, il existe donc deux phénomènes possibles, soit un court-circuit (la varistance est détruite reliant la phase à la terre ou la phase au neutre ou entre phase), soit l'emballement thermique expliqué ci-dessus.

Pour le court-circuit, Il est connu d'installer un organe de déconnexion électrique (disjoncteur ou fusible) en série avec l'appareil électrique contre les surtensions transitoires, l'ensemble étant en parallèle de l'installation du tableau électrique, juste en aval de la première protection principale du tableau électrique.

Pour éviter le problème d'emballement thermique dans l'installation électrique, les appareils électriques contre les surtensions transitoires comportent une déconnexion thermique de la varistance qui déconnecte celle-ci du réseau en cas d'échauffement important. Cette déconnexion thermique doit réagir très rapidement selon la norme NF EN 61643-11 (déconnexion en moins de 5s pour l'essai de défaillance) mais tout en maintenant les caractéristiques de protection foudre.

La déconnexion thermique sert à déconnecter électriquement la varistance de l'installation électrique à protéger en cas d'échauffement excessif de la varistance, par exemple au-delà de 150°C. La déconnexion thermique comprend souvent une soudure basse température maintenant en place un élément conducteur électriquement contraint élastiquement contre une borne de la varistance, la soudure fond au-delà d'une température prédéterminée et entraine une déconnexion de la varistance permettant le déplacement de cet élément avec pour effet d'ouvrir le circuit de la varistance. Le document FR2 984 006 décrit une telle déconnexion.

Notamment il est connu dans la norme au moins trois type d'appareil électrique contre les surtensions transitoires, type 1, type 2, type 3. L'appareil électrique contre les surtensions transitoires de type 1 est capable d'écouler un courant de foudre très important, de la terre vers le réseau de distribution d'énergie ou l'inverse. L'appareil électrique contre les surtensions transitoires type 2 permet d'écouler les courants générés par des coups de foudres indirects et provoquant des surtensions induites ou conduites sur le réseau de distribution d'énergie. L'appareil électrique contre les surtensions transitoires type 3 est installé en complément des types 2 pour réduire la surtension aux bornes des équipements sensibles. Leur capacité d'écoulement de courant est très limitée. En conséquence ils ne peuvent être utilisés seuls.

Il existe donc pour les hautes puissances, il est connu d'utiliser des appareils électriques contre les surtensions transitoires de type 1 ou type 1+2 dans lequel plusieurs varistances sont montés, appelées aussi dispositif de varistances ou encore une varistance double lorsqu'il y a en a que deux.

De manière générale, la déconnexion thermique pour les dispositifs de varistances est une connexion par une soudure entre la borne de connexion de chaque varistance et une patte de connexion électrique de l'appareil électrique contre les surtensions transitoires, qui fond au-delà d'une température prédéterminée permettant à la patte de connexion électrique de s'écarter de la borne de la varistance et donc déconnecte la varistance. Ainsi, la soudure est située entre la varistance et la patte de connexion de l'appareil et la déconnecte dès que la température prédéterminée est atteinte. C'est notamment le cas du document EP 2 633 530. Enfin, pour éviter la formation d'arc électrique entre la borne de connexion de la varistance et la patte de connexion, il peut avoir un écran isolant qui se déplace entre la borne de connexion de la varistance et la patte de connexion permettant d'éteindre un arc électrique. Le document FR2869155 résout ce problème en ajoutant des écrans isolants qui se déplace entre la patte de connexion et la borne de connexion ainsi qu'entre la patte de connexion et une borne de connexion de l'appareil. Ce document montre un tel système lorsqu'il y a deux varistances en parallèle.

Un problème de ces déconnexions est d'une part que comme la soudure a une résistance, elle produit de la chaleur par perte joules par le courant la traversant qui ne correspond pas à celle de la varistance. Ainsi la déconnexion thermique peut être effectuée alors que la varistance est encore utilisable. En outre la résistance d'une varistance défectueuse produit un effet indésirable sur le reste du réseau de l'installation.

Il est connu aussi des organes thermosensibles tels que des bilames permettant de se déformer au-delà d'une température prédéterminée. Cependant de telles organes thermosensibles sont volumineux et se détériore à chaque montée en température pouvant ainsi se déformer avant la fin de vie de la varistance. Enfin de tels organes thermosensibles peuvent se déformer trop lentement lorsque la température prédéterminée est atteinte en particulier si celle-ci est montée rapidement et est très éloignée de la température ambiante.

En outre dans ces appareils électriques comprenant un dispositif de varistances, dans le cas d'une varistance déconnectée, l'autre ou les autres varistances reste(nt) connectée(s) et l'appareil électrique contre les surtensions transitoires n'est plus de type 1 ou 1+2 du fait qu'une seule des varistances est déconnectée ce qui peut entraîner une mauvaise protection en cas d'une surtension importante. Dans le cas d'une varistance détruite ouverte, l'autre varistance devra supporter toute la surtension et dans le cas de la varistance détruite fermé (court-circuité) un déclencheur externe se déclenche.

Le document DE 10 2010 008537 A1 divulgue un appareil électrique contre les surtensions transitoires comprenant plusieurs varistances et deux déclencheurs qui pourtant ne comportent aucun scellement.

Ainsi il est nécessaire de trouver un dispositif de protection thermique de composant de protection pour les parafoudres permettant de résister au-delà d'une température prédéterminée pour éviter une déconnexion intempestive dû à certain parafoudre qui monte en température en utilisation normale tout en se déconnectant en moins de 5 secondes au-delà d'une température anormale.

De ce fait il y a un besoin de trouver une autre solution pour ces appareils à double varistances permettant d'assurer la sécurité.

### RESUME DE L'INVENTION

L'invention offre une solution à au moins un des problèmes évoqués précédemment, en permettant d'avoir un système déconnectant l'appareil électrique contre les surtensions transitoires dès lors qu'une des varistances est défaillante.

Un aspect de l'invention concerne un appareil électrique contre les surtensions transitoires comprenant :
- un logement destiné à recevoir un dispositif de varistances à détection d'emballement thermique comprenant au moins :
   - un ensemble de varistances,
   - un premier détecteur thermique d'une varistance et un deuxième détecteur thermique d'une autre varistance, comprenant chacun un scellement à déconnexion thermique se descellant au-delà d'une température prédéterminée de sécurité,
- une première borne de liaison destinées à être reliée indépendamment à un réseau d'alimentation ou à la terre, s'étendant en outre dans le logement pour être connectée à l'ensemble de varistances, et
- un dispositif de protection thermique comprenant :
   - une première zone de déclenchement destinée à se déclencher lorsque le scellement du premier détecteur thermique se descelle,
   - une deuxième zone de déclenchement différente de la première zone de déclenchement, destinée à se déclencher lorsque le scellement du deuxième détecteur thermique se descelle,
- le dispositif de protection thermique étant agencé pour que si la première zone ou la deuxième zone se déclenche, le dispositif thermique déconnecte électriquement l'ensemble de varistances de la première borne de liaison électrique.

Grâce à l'invention, le dispositif de protection thermique permet de déconnecter l'ensemble des varistances dès lors qu'une des varistances est défaillante. Ainsi si l'une des deux zones se déclenche sans que l'autre zone ne se déclenche, le dispositif de protection thermique permet de déconnecter l'ensemble des varistances permettant d'avoir un dispositif de protection rapide.

Par scellement, on entend une soudure ou un collage ou un brasage.

Par déconnecter électriquement l'ensemble des varistances, on entend déconnecter électriquement toutes les varistances de l'ensemble des varistances.

Ainsi, dès qu'une des varistances est défectueuse, l'ensemble des varistances est déconnecté permettant ainsi de ne pas protéger l'installation selon une mauvaise protection en cas d'une surtension importante et ainsi inciter l'utilisateur à changer au moins l'ensemble varistances.

Selon un aspect de l'invention, l'invention concerne aussi un dispositif de varistances à détection d'emballement thermique pour un appareil électrique contre les surtensions transitoires décrit précédemment, le dispositif de varistance à détection d'emballement thermique comprenant :
- un ensemble de varistances comprenant :
   - au moins une première borne de connexion destinée à être connectée à la première borne de liaison électrique de l'appareil électrique contre les surtensions transitoires pour relier l'ensemble de varistances au réseau ou la terre de l'installation et
   - une première et deuxième varistance comprenant chacune indépendamment une patte de déconnexion thermique ,
   - la première borne de connexion étant distincte des pattes de déconnexion thermique,
- un premier détecteur thermique et un deuxième détecteur thermique comprenant chacun un scellement fixé à respectivement la première et deuxième patte à déconnexion thermique se descellant au-delà d'une température prédéterminée de sécurité.

Le dispositif de varistance à détection d'emballement thermique comprend ainsi un détecteur thermique par varistance et une première borne de connexion destinée à être connectée à la première borne de liaison électrique de l'appareil électrique contre les surtensions transitoires permettant ainsi au détecteur thermique par varistance de détecter une surchauffe de sa varistance et ainsi que le dispositif de protection thermique puisse déconnecter électriquement l'ensemble des varistances dans le cas d'une détection thermique par un seul des détecteurs thermiques.

L'invention concerne aussi une cassette d'un parasurtenseur comprenant un appareil électrique contre les surtensions transitoires selon l'invention décrit précédemment et un ensemble de varistances selon l'invention décrit précédemment monté dans le logement de l'appareil électrique contre les surtensions transitoires, la première borne de liaison électrique étant en contact électriquement et physiquement avec l'au moins une première borne de connexion et en ce que le premier détecteur thermique et le deuxième détecteur thermique sont chacun agencé avec respectivement la première zone de déclenchement et la deuxième zone de déclenchement pour que le dispositif thermique déconnecte électriquement l'ensemble de varistances de la première borne de liaison électrique.

L'invention concerne en outre un parasurtenseur comprenant un socle et une cassette selon l'invention décrite précédemment montée sur le socle, le socle comprenant des bornes de branchement en contact physiquement et électriquement avec les bornes de liaisons pour relier les bornes de liaisons au réseau électrique.

Enfin l'invention concerne aussi un procédé de déconnexion électrique d'un ensemble de varistances de la cassette selon l'invention décrit précédemment comprenant:
- une étape de déscellement du premier détecteur thermique d'une varistance ou du deuxième détecteur thermique d'une autre varistance de l'ensemble de varistances de respectivement,
- après l'étape de descellement, une étape de déclenchement respectivement de la première zone ou de la deuxième zone de déclenchement du dispositif de protection thermique, et
- après l'étape de descellement, une étape de déconnexion électrique de l'ensemble de varistances de la première borne de liaison électrique.

Ainsi si l'un des détecteurs thermiques (premier ou deuxième détecteur thermique) se descelle (sans que l'autre détecteur thermique se descelle) cela entraine le déclenchement de la zone correspondante, c'est à dire sans que l'autre zone ne se déclenche, et le dispositif de protection thermique permet de déconnecter l'ensemble des varistances permettant d'avoir un dispositif de protection rapide.

Outre les caractéristiques qui viennent d'être évoquées dans le paragraphe précédent, l'appareil électrique contre les surtensions transitoires selon un aspect de l'invention peut présenter une ou plusieurs caractéristiques complémentaires parmi les suivantes, considérées individuellement ou selon toutes les combinaisons techniquement possibles :

Selon un mode de réalisation, la première borne de liaison est connectée à la terre ou à une phase ou à un neutre du réseau et en ce qu'il comprend une deuxième borne de liaison connectée respectivement à une phase ou à un neutre du réseau ou à la terre et comprend une patte de connexion pour se connecter électriquement et physiquement à une deuxième borne de connexion de l'ensemble de varistance.

Selon un mode de réalisation du dispositif de varistances à détection d'emballement thermique, chaque varistance comprend une première borne de connexion destinée à être connectée électriquement et en contact avec la première borne de liaison électrique. Dans cet exemple, le nombre d'au moins une première borne de connexion est égale aux nombres de varistances.

Selon un mode de réalisation de l'appareil électrique contre les surtensions transitoires, la première borne de liaison électrique comprend un bras par varistance destiné chacun à se connecter et être en contact avec la première borne de connexion de la varistance correspondante.

Selon un mode de réalisation de la cassette comprenant un appareil selon le mode de réalisation précédent et un dispositif de varistance selon le mode de réalisation précédent, chaque bras de la première borne de liaison électrique est plaqué contre la première borne de connexion de la varistance correspondante formant un contact électrique.

Selon un mode de réalisation du dispositif de varistances à détection d'emballement thermique, l'ensemble varistance comprend une deuxième borne de connexion située électriquement à l'opposé de l'au moins une première borne de connexion.

Selon un mode de réalisation de l'appareil électrique contre les surtensions transitoires, l'appareil comprend en outre une deuxième borne de liaison électrique adaptée à être connectée à une deuxième borne de connexion de l'ensemble de varistances.

Selon un mode de réalisation de la cassette comprenant un appareil selon le mode de réalisation précédent et un dispositif de varistance selon le mode de réalisation précédent, la deuxième borne de liaison électrique est en contact électriquement et physiquement avec la deuxième borne de connexion de l'ensemble de varistances.

Selon un mode de réalisation de l'appareil électrique contre les surtensions transitoires, dans lequel :
- la première borne de liaison électrique est mobile entre une position initiale dans laquelle elle est adaptée à être en contact avec une première borne de connexion de l'ensemble varistance, et une position déconnectée dans laquelle la première borne de liaison électrique est adaptée à être éloignée de la première borne de liaison de l'ensemble varistance pour déconnecter électriquement l'ensemble de varistances de la première borne de liaison électrique, et
- la première borne de liaison électrique est séparée et éloignée de la première et de la deuxième zone de déclenchement. et en ce que le dispositif de protection thermique permet l'ouverture du contact d'alimentation pour déconnecter les varistances de la première borne de liaison.

Ainsi, le courant traversant la varistance ne passe pas par le dispositif de protection thermique.

Selon un exemple de ce mode de réalisation, la première borne de liaison électrique comprend une épingle comprenant une partie centrale destinée à être reliée à une première borne de raccordement de phase pour être reliée au réseau ou à la terre et un bras de contact mobile par varistance, destiné à être en contact physiquement et électriquement chacun avec la première borne de connexion de la varistance correspondante en position connectée et éloignée chacun de la borne de connexion de la varistance correspondante en position déconnectée.

Selon une mise en oeuvre de cet exemple, chaque bras de contact mobile est déformé élastiquement par le dispositif de protection thermique en position initiale et en ce que le déplacement du dispositif de protection thermique en position déconnectée libère chaque bras de contact mobile qui revient dans sa forme initiale dans la position déconnectée.

Selon une mise en oeuvre de cet exemple, chaque bras de contact mobile est naturellement en contact avec la première borne de connexion correspondante en position initiale, le dispositif de protection thermique peut assurer un plaquage de chaque bras de contact mobile contre la première borne de connexion et en ce que le déplacement du dispositif de protection thermique en position déconnectée écarte chaque bras de contact mobile de sa forme initiale vers une position déconnectée déformée élastiquement.

Selon un mode de réalisation, le dispositif de protection thermique comprend un cavalier mobile entre une position initiale et une position déconnectée, dans laquelle le cavalier comprend la première et la deuxième zone de déclenchement, chaque zone de déclenchement étant une butée par varistance destinée pour être retenue par le détecteur thermique correspondant.

Selon un exemple de ce mode de réalisation, le dispositif de protection thermique comprend un moyen de déplacement élastique comprenant une position comprimée contre le cavalier en position initiale et une position détendue contre le cavalier en position déconnectée.

Par détendu, on entend détendu par rapport à la position comprimée. Autrement dit en position détendue, le moyen de déplacement élastique peut être comprimé en position déconnectée mais moins comprimé (plus détendu) qu'en position connecté.

Selon une mise en oeuvre de cet exemple de ce mode de réalisation, le moyen élastique est monté, comprimé, entre le cavalier et une paroi d'appui de l'appareil électrique contre les surtensions transitoires.

Selon une mise en oeuvre de cet exemple, le moyen élastique comprend deux ressorts de déplacement agencés par exemple de façon concentriques. Cela permet d'améliorer la force de pression pour ouvrir le contact d'alimentation. Dans le cas où le contact d'alimentation est une épingle à deux bras mobiles, cela permet d'écarter les bras mobiles de chaque borne de connexion des varistances.

Selon une mise en oeuvre de cet exemple, le moyen élastique est en appui contre un cache amovible permettant ainsi d'installer le moyen de déplacement en dernier lors du procédé de fabrication du dispositif de protection thermique.

Selon une mise en oeuvre de cet exemple de ce mode de réalisation et du mode de réalisation précédent, le cavalier comprend :
- un verrou rotatif en appui sur les deux pattes de retenu en position initiale,
- un séparateur isolant,
- et en ce que lorsqu'il y a un descellement d'un scellement à déconnexion thermique d'une varistance en fin de vie, le verrou rotatif se déplace de la position initiale à la position déconnectée en se déplaçant en rotation et en translation permettant de s'éloigner de l'au moins un scellement et le séparateur isolant se déplace de la position initiale à la position déconnectée en translation en s'interposant dans un contact d'alimentation entre la première borne de liaison et des bornes de connexion électrique des varistances.

Selon une mise en oeuvre de cet exemple de ce mode de réalisation, le cavalier comprend une partie conductrice et en ce que la partie conductrice est en contact électrique avec la première borne de liaison électrique et est destinée à être en contact électriques avec les bornes de connexions des varistances en position initiale et est éloignées des bornes de connexion ou/et de la bornes de liaison en position déconnecté.

Selon une mise en oeuvre de cet exemple de ce mode de réalisation, le cavalier comprend un écarteur écartant élastiquement des bras de contact de la première borne de liaison électrique en position initiale pour être en contact avec les premières bornes de connexion.

Selon un mode de réalisation, l'appareil électrique contre les surtensions transitoires comprend :
- un boîtier comprenant le logement et une fenêtre d'identification, et
- un indicateur d'états comprenant une première marque et une deuxième marque d'indications d'états différentes l'une de l'autre et en ce que l'indicateur d'états est mobile de la position initiale dans lequel la première marque d'indication d'état est visible de l'extérieur par la fenêtre d'identification à une position d'information dispositif défectueux dans lequel le dispositif de protection thermique est en position déconnectée et la deuxième marque d'état est visible de l'extérieur par la fenêtre d'identification.

Selon un exemple de ce mode de réalisation et du mode de réalisation précédent, l'indicateur d'états est monté sur le cavalier mobile.

Selon une mise en oeuvre de cet exemple, dans lequel le cavalier comprend un séparateur isolant, l'indicateur d'états est situé sur le séparateur isolant.

Selon une variante de cette mise en oeuvre de cet exemple, dans lequel le cavalier comprend un verrou rotatif, l'indicateur d'états est situé sur le verrou rotatif.

Selon un mode de réalisation du dispositif de varistances à détection d'emballement thermique, l'ensemble de varistances comprend par varistance une première plaque de contact conductrice électriquement comprenant la patte de déconnexion thermique et la première borne de connexion de façon distincte l'une de l'autre. Cela permet d'utiliser la plaque de contact pour former la patte de déconnexion thermique afin de simplifier l'ensemble de varistances.

Selon un exemple de ce mode de réalisation du dispositif de varistances à détection d'emballement thermique, comprenant deux ensembles séparés et distinct l'un de l'autre, comprenant chacun une varistance de l'ensemble de varistances, chaque varistance d'un ensemble comprenant :
- la première plaque de contact conductrice électriquement comprenant la patte de déconnexion thermique et la première borne de connexion de façon distincte l'une de l'autre,
- une deuxième plaque latérale pour être connectée à une deuxième borne de liaison de l'appareil et
- un bloc de céramique entre les deux plaques latérales est connecté physiquement et électriquement au bloc de céramique, et
- le premier ou deuxième détecteur thermique scellée à la patte de déconnexion thermique.

La deuxième plaque peut aussi se connecter électriquement à l'autre deuxième plaque de l'autre varistance de l'autre boc qui comprend en outre une borne de liaison pour se connecter à la terre ou au réseau.

Chaque varistance peut avoir un isolant entourant les deux plaques latérales et le bloc de céramique pour la protéger et en ce que les premières et deuxième borne de connexion et la patte de déconnexion thermique s'étendent en dehors de l'isolant.

Selon un autre exemple de ce mode de réalisation du dispositif de varistances à détection d'emballement thermique, l'ensemble de varistances est une varistance double comprenant :
- un bloc de céramique par varistance,
- une plaque de contact centrale entre les deux blocs de céramique,
- dans lequel la première plaque de contact est une plaque de contact latérale contiguë avec un des deux blocs à l'opposé de la plaque de contact centrale, et la deuxième plaque de contact latérale comprenant la patte de déconnexion thermique est contigüe avec l'autre bloc.

Selon un mode de réalisation du dispositif de varistances à détection d'emballement thermique, le scellement est une brasure. Cela permet d'avoir une patte de déconnexion thermique dans une matière permettant une bonne conduction thermique de la varistance à la soudure tel que par exemple du cuivre.

Selon un exemple, la brasure est une brasure comprenant de l'étain et un élément parmi le Zinc, l'argent et le cuivre. Cela permet de fondre sans plomb

Selon une particularité, cette brasure est eutectique et est de préférence Zinc et étain. Cela permet de fondre en moins de 5 secondes et de répondre à nouvelle directive de la Rohs qui interdit l'utilisation du plomb. Cette brasure permet de fondre rapidement en moins de 5 secondes en cas de dépassement de la température au-delà d'un seuil de température de sécurité d'emballement thermique.

Selon un mode de réalisation du dispositif de varistances, le premier détecteur thermique et le deuxième détecteur thermique sont éloignés l'un de l'autre par l'ensemble de varistance.

Selon un mode de réalisation du dispositif de varistances, le premier détecteur thermique et le deuxième détecteur thermique comprennent en outre chacun respectivement une première et une deuxième patte de retenu scellées chacune respectivement à la patte de déconnexion thermique de la première et deuxième varistance pour se desceller à partir d'une température prédéterminée de sécurité.

Selon un mode de réalisation du dispositif de varistances l'ensemble varistance comprend un corps externe isolant entourant chaque composant varistance, le corps externe comprenant :
- deux parois latérales dont au moins une des parois latérales est adjacente d'une paroi latérale d'une varistance adjacente,
- un contour reliant les deux parois latérales et
- en ce que la patte de déconnexion s'étend du contour du corps externe vers l'extérieur en ayant une extrémité à distance du corps externe.

Cela permet de pouvoir accoler plusieurs varistances accolées, la varistance la moins usée (ayant une impédance plus importante) sera chauffée par sa ou ses varistances voisines et ainsi refroidir la varistance voisine sans refroidir la patte de déconnexion. En effet, la varistance a une inertie pouvant réduire la température de la varistance par rapport à cette même varistance utilisée seule. Le fait que la patte de déconnexion s'étend du contour du corps externe permet en outre d'être dans une des zones les plus chaude de la varistance.

Selon un mode de réalisation, chaque varistance comprend une patte de déconnexion thermique et en ce que l'appareil électrique comprend un deuxième dispositif de protection thermique soudé aux deuxièmes pattes de déconnexion thermique de chaque varistance par une autre soudure, le deuxième dispositif de protection thermique étant agencé pour que si une des autre soudures fond, le deuxième dispositif thermique déconnecte l'ensemble des varistances en parallèle .

Cela permet d'avoir une protection thermique redondante dans le cas où une varistance en fin de vie est plus chaude d'un côté d'une patte de déconnexion thermique qu'un autre côté d'une autre patte de déconnexion thermique.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
[Fig. 1] représente une vue en éclatée d'une cassette comprenant un appareil électrique contre les surtensions transitoires selon un exemple d'un premier mode de réalisation et un dispositif de varistances à détection d'emballement thermique.
[Fig. 2A] représente une vue en perspective d'une partie d'un parasurtenseur comprenant une partie de la cassette selon l'exemple de la figure 1 dans une position initiale.
[Fig. 2B] représente un agrandissement d'une portion de la figure 2A.
[Fig. 2C] représente une vue en perspective d'une partie de la cassette de la figure 1.
[Fig. 2D] représente une vue en perspective du parasurtenseur avec une coupe du dispositif de protection thermique 2.
[Fig. 3A] représente une vue en perspective d'une partie du parasurtenseur dans une position déconnectée.
[Fig. 3B] représente un agrandissement d'une portion de la partie du parasurtenseur de la figure 3A.
[Fig. 4] représente une vue en perspective de la cassette selon l'exemple de la figure 1.
[Fig. 5] représente une vue en perspective du parasurtenseur comprenant la cassette selon l'exemple de la figure 1.
[Fig.6] représente une vue en éclatée d'un exemple d'un ensemble varistance de la cassette de la figure 1.

### DESCRIPTION DETAILLEE

Les figures sont présentées à titre indicatif et nullement limitatif de l'invention.

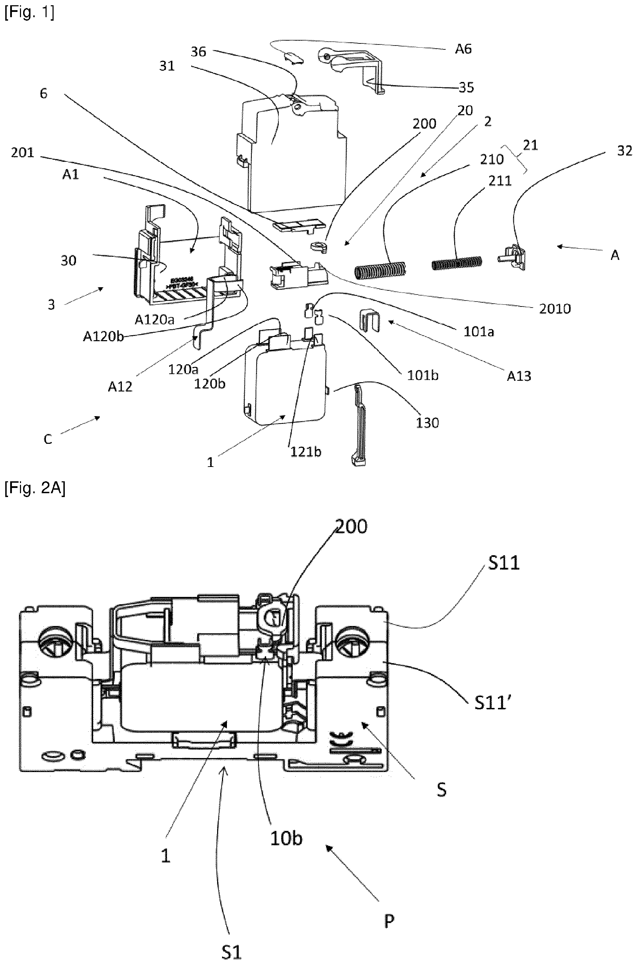

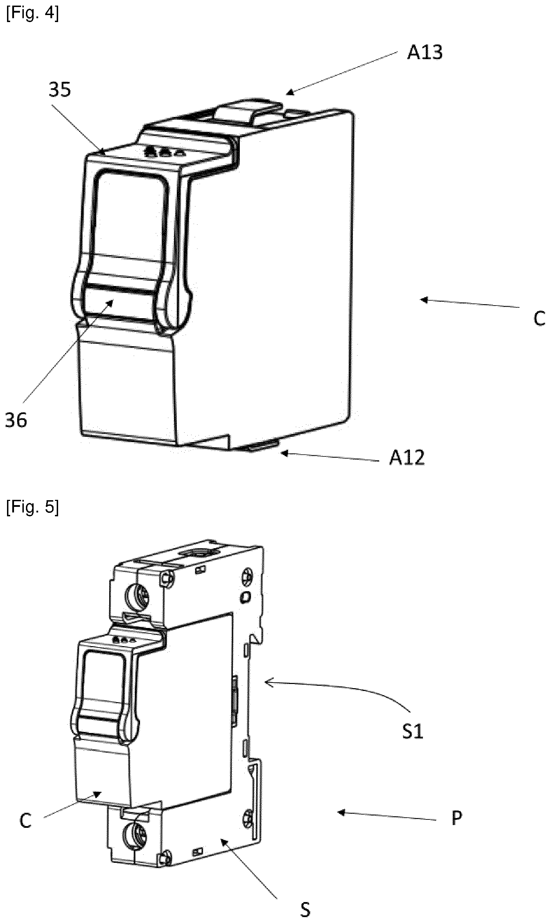

La figure 1 représente une vue en éclatée d'une cassette C visible assemblée sur la figure 4 d'un parasurtenseur P visible sur la figure 5. La cassette C comprend un appareil électrique contre les surtensions transitoires A selon un exemple d'un premier mode de réalisation et un dispositif de varistances à détection d'emballement thermique 1 selon un exemple d'un premier mode de réalisation. L'appareil électrique contre les surtensions transitoires A comprend un logement A1 dans lequel est situé le dispositif de varistances à détection d'emballement thermique 1. L'appareil électrique contre les surtensions transitoires A comprend au moins un dispositif de protection thermique 2 du dispositif de varistances à détection d'emballement thermique 1 décrit ensuite.

Dans cet exemple de ce mode de réalisation, l'appareil électrique contre les surtensions transitoires A comprend un boîtier 3 comprenant des parois formant le logement A1. Le boitier 3 comprend une base 30 et un couvercle 31 s'emboîtant ensemble formant le logement A1.

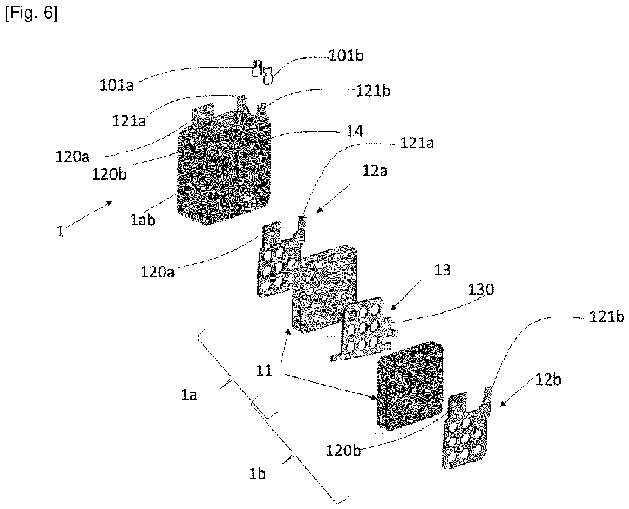

La figure 6 représente une vue en éclatée du dispositif de varistances à détection d'emballement thermique 1 telle que celle représentée sur la figure 1, comprenant un ensemble de varistances 1ab. Par ensemble de varistances, on entend au moins deux varistances. En outre sur cette figure 6 est représenté l'ensemble de varistances 1ab assemblé.

Dans cet exemple, l'ensemble de varistances 1ab est une double varistance 1ab comprenant donc deux varistances 1a, 1b. Chaque varistance 1a, 1b comprend chacune un bloc céramique 11 composé d'oxydes métalliques et une première et une deuxième plaque de contact conductrice électriquement 12a, 12b, 13. Dans cet exemple, l'ensemble varistance 1ab comprend une plaque de contact centrale 13 contiguë contre deux faces latérales des deux blocs céramiques et deux plaques de contact latérale 12a, 12b contiguë chacune contre une face latérale d'un bloc céramique 11 correspondant. Ainsi on utilise une seule plaque de contact centrale 13 pour former une borne des deux varistances 1a, 1b, c'est à dire que la plaque de contact centrale 13 fait partie des deux varistances 1a, 1b comprenant chacune en outre le blocs céramique 11 correspondant et la plaque de contact latérale 12a, 12b correspondant.

En l'occurrence les plaques de contact 12a, 12b, 13 sont en cuivre.

Selon un exemple non représenté, l'ensemble de varistances 1ab comprend trois ou plus de blocs céramiques et peut avoir plus de plaques de contact centrale 13, par exemple il peut y avoir Y plaques de contact centrales 13 égale à N bloc céramique moins un.

L'ensemble de varistances 1ab comprend en outre un isolant 14 formant un corps externe de l'ensemble isolant et enveloppant les blocs de céramique 11 et une partie des plaques conductrices latérales 12a, 12b et centrale 13.

Dans cet exemple, l'ensemble varistance 1ab comprend une patte de déconnexion thermique 121a, 121b par varistance 1a, 1b qui est située sur une plaque de contact latérale 12a, 12b et s'étend en dehors de l'isolant 14. Dans le cas de l'exemple précédent non représenté, des varistances peuvent comprendre des pattes de déconnexion thermique sur une plaque de contact centrale 13. Cependant dans cet exemple non représenté les deux blocs influencent thermiquement sur les deux pattes de protection thermique alors que le fait d'avoir les pattes de déconnexion thermique 121a, 121b contre les bords latéraux des blocs permet d'améliorer la sensibilité thermique de la chaleur de chacune des deux varistances 1a, 1b.

Selon un autre exemple non représenté, la plaque de contact conductrice centrale 13 comprend une patte de déconnexion thermique et donc l'ensemble de varistances comprend trois pattes de déconnexion thermique.

Selon encore une variante non représentée, l'ensemble de varistances comprend une autre plaque de contact thermique par bloc comprenant la patte de déconnexion thermique. Par exemple la plaque de contact thermique est dans une matière ayant une meilleure conductivité thermique que la matière de la plaque de contact conductrice latérale ou centrale.

Chaque varistance 1a, 1b comprend une première borne de connexion électrique 120a, 120b et une deuxième borne de connexion électrique 130. Dans cet exemple, la première borne de connexion électrique 120a, 120b fait partie de la plaque de contact conductrice latérale 12a, 12b et s'étend en dehors de l'isolant et la deuxième borne de connexion électrique 130 fait partie de la plaque de contact conductrice centrale 13 et s'étend en dehors de l'isolant. L'ensemble de varistances 1ab comprend donc dans cette exemple une première borne de connexion électrique 120a, 120b par varistance soit en l'occurrence deux premières bornes de connexion électrique 120a, 120b.

Le dispositif de varistances à détection d'emballement thermique 1 comprend en outre au moins deux détecteurs thermique. Dans ce mode de réalisation, le dispositif de varistances à détection d'emballement thermique 1 un premier détecteur thermique 10a et un deuxième détecteur thermique 10b comprenant chacun un scellement fixé à respectivement la patte de déconnexion thermique 121a, 121b de la première et deuxième varistance 1a, 1b se descellant au-delà d'une température prédéterminée de sécurité.

Dans ce mode de réalisation, le premier détecteur thermique 10a et le deuxième détecteur thermique 10b comprennent chacun une première patte de retenue 101a scellée à la première patte de déconnexion thermique 121a et une deuxième patte de retenue 101b différente de la première patte de retenue 101a, scellée avec le scellement (non représenté) à la deuxième patte de déconnexion thermique121b.

Chaque patte de retenue 101a, 101b est dans cet exemple de type cosse pour diminuer les coûts, mais pourrait avoir une autre forme, par exemple en équerre.

Le scellement est conçu pour se desceller à une température prédéterminée, par exemple une température prédéterminée entre 170 et 250°C. Le scellement peut être par une soudure ou une brasure ou encore un collage par exemple une colle ou un ruban adhésif.

Le scellement est en l'occurrence réalisé par une brasure, en particulier une brasure eutectique.

Le scellement peut aussi être une soudure eutectique comprenant 99,25% d'étain et 0,75% de cuivre ou autres.

L'appareil électrique contre les surtensions transitoires A comprend en outre une première borne de liaison électrique A12 et une deuxième borne de liaison électrique A13 destinées à être chacune reliée indépendamment à un réseau d'alimentation ou à la terre et aux varistances de l'ensemble varistances 1ab. En l'occurrence les deux bornes de connexion sont en cuivre.

Dans cet exemple de ce mode de réalisation, la première borne de liaison électrique A12 comprend un premier et un deuxième bras de contact A120a, A120b s'étendant dans le logement A1 pour former avec chaque première borne de connexion 120a, 120b un contact d'alimentation. Le fait d'avoir deux contacts d'alimentations par la première borne de liaison permet de faciliter la déconnexion expliqué ensuite en cas d'arc électrique. En effet, l'arc électrique peut provoquer une force de retenu du contact d'alimentation en positon fermé.

Chaque première borne de connexion 120a, 120b est donc en contact avec un des deux bras A120a, A120b correspondants. Autrement dit, un bras A120a est en contact avec la première borne de connexion 120a de la plaque de contact latérale 12a de la première varistance 1a et l'autre bras A120b est en contact avec la première borne de connexion120b de la plaque de contact latérale 12b de la deuxième varistance 1b. La deuxième borne de connexion A13 comprend une partie connectique A130 s'étendant dans le logement en prise avec la deuxième borne de connexion 130 de l'ensemble de varistances 1ab.

L'appareil électrique contre les surtensions transitoires A comprend en outre un dispositif de protection thermique 2 dans le logement A1. Le dispositif de protection thermique 2 comprend une première zone de déclenchement destinée à se déclencher lorsque le scellement du premier détecteur thermique 10a se descelle et une deuxième zone de déclenchement différente de la première zone de déclenchement, à se déclencher lorsque le scellement du deuxième détecteur thermique 10b se descelle et est en outre agencé pour que si la première patte de retenue 101a ou la deuxième patte de retenue 101b se descelle respectivement de la première ou la deuxième patte de déconnexion thermique 121a, 121b, le dispositif de protection thermique 2 déconnecte électriquement l'ensemble des varistances 1ab de la première borne de liaison électrique A12.

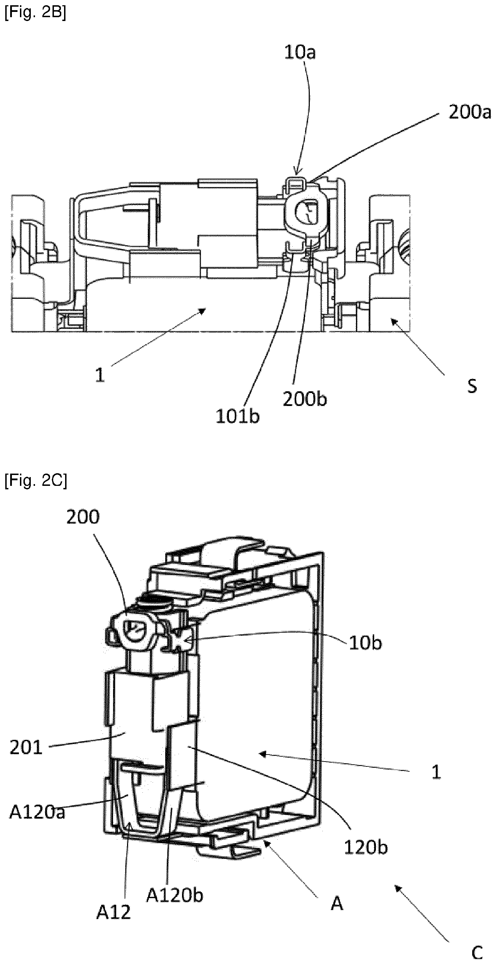

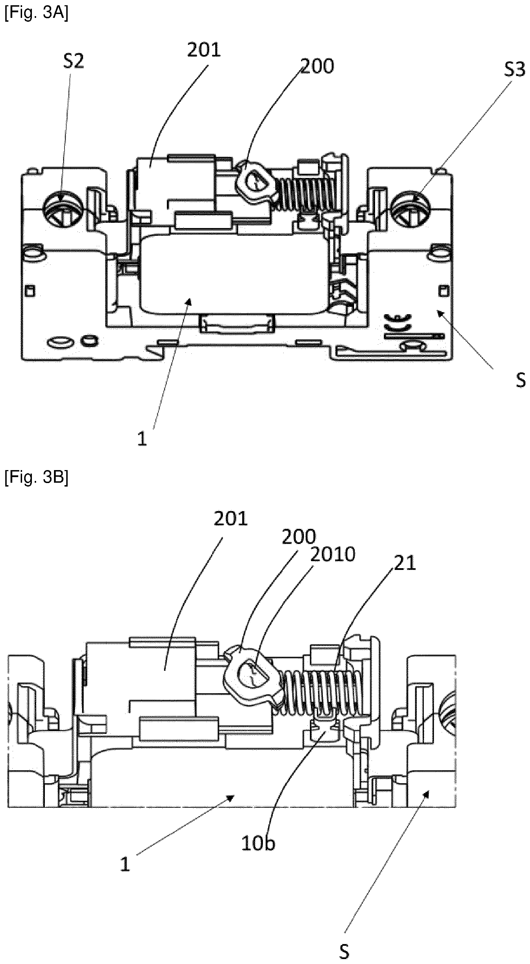

Le dispositif de protection thermique 2 comprend notamment un cavalier 20 mobile entre une position initiale, représentée sur les figures 2A, 2B, et 2C, dans lequel le cavalier 20 comprend la première et la deuxième zone de déclenchement qui sont en l'occurrence des butées 200a, 200b en contact respectivement avec les pattes de retenues 101a, 101b scellées chacune à la patte de déconnexion thermique 121a, 121b correspondante et une position déconnectée, représentée sur les figures 3A, 3B dans laquelle le cavalier 20 est agencé pour ouvrir les contacts d'alimentations des varistances 1a, 1b et dans laquelle une des pattes de retenue 101a, 101b est descellée de la patte de déconnexion thermique 121a, 121b correspondante.

Selon cet exemple, les pattes de retenue 101a, 101b sont scellées chacune respectivement sur une surface de la patte de déconnexion thermique 121a, 121b correspondante à l'opposé des butées 200a, 200b du cavalier 20. Cela permet de diminuer le risque de blocage du déplacement du cavalier 20 par la patte de retenue 101a, 101b descellée tout en réduisant le volume de l'appareil. En l'occurrence la surface de chaque patte de déconnexion thermique 121a, 121b sur laquelle est scellée la patte de retenue 101a, 101b correspondante est une surface externe et donc les butées 200a, 200b sont situées entre les pattes de déconnexion thermique 121a, 121b. Chaque patte de retenu 101a, 101b comprend donc dans cet exemple une base scellée et un ergot s'étendant de la base vers l'intérieur soit vers les butées 200a, 200b. En l'occurrence chaque ergot s'étend de la base au-dessus de l'extrémité de la patte de déconnexion thermique 121a, 121b pour permettre d'augmenter la course du cavalier 20 et en outre peut permettre de guider la patte de retenue 101a,101b sur la patte de déconnexion thermique 121a, 121b lors du scellement.

Selon un autre exemple non représenté, l'ergot s'étend de la base vers la butée correspondante le long d'un bord de la patte de déconnexion thermique 121a, 121b entre celle-ci et les bornes de connexion 120a, 120b ou l'appui d'un moyen élastique 21 expliqué dans la suite en détail. Selon une mise en oeuvre non représenté, et en particulier pour l'exemple non représenté, la butée ou/et l'ergot a une surface de contact en biseau pour que la force exercée des butées sur chaque patte de retenue comprend une composante vers l'extérieur pour écarter les pattes de retenue 10a, 10b des butées 200a, 200b pour ne pas empêcher le déplacement du cavalier 20 vers la position de déconnexion lors d'un descellement.

Le cavalier 20 est de préférence dans une matière isolante électriquement.

Selon un autre exemple non représenté, le cavalier 20 est dans une matière conductrice électriquement.

La résistance électrique de contact entre chaque bras de contact A120a, A120b et la première borne de connexion 120a, 120b est dans ces deux exemples, inférieure à la résistance électrique entre le dispositif de protection thermique 2 et les pattes de protection thermique 121a, 121b.

Le cavalier mobile 20 est, dans ce mode de réalisation, monté comprimé dans la position initiale et est donc retenu par les pattes de retenues 101a, 101b. Lorsqu'une des pattes de retenues 20a, 20b est descellée, le cavalier mobile 20 se déplace vers sa position déconnectée en éloignant chaque bras de contact A120a, A120b de la borne de liaison A12 de la première borne de connexion 120a, 120b correspondante pour ouvrir les contacts d'alimentation des varistances 1a, 1b.

Le dispositif de protection thermique 2 comprend en outre le moyen élastique 21, par exemple un ressort de déplacement. Dans cet exemple, le moyen élastique 21 est, monté comprimé entre le cavalier 20 et une paroi d'appui du boitier 3 de l'appareil électrique contre les surtensions transitoires A.

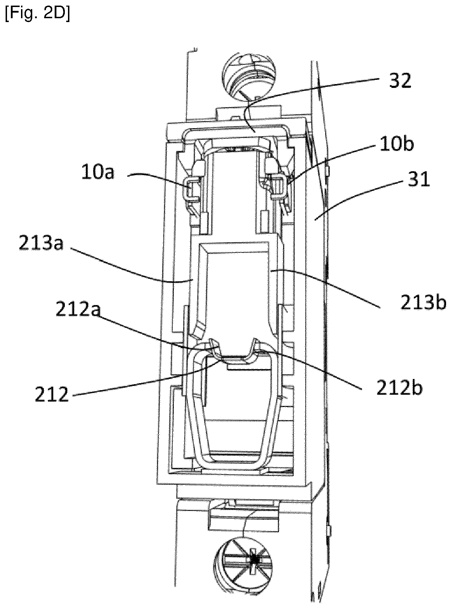

La figure 2D représente une vue en coupe du dispositif de protection thermique 2.

Dans cet exemple de ce mode de réalisation, les bras de contact A120a, A120b sont montés en position initiale (en position connectée) en contact avec les premières bornes de connexion 120a, 120b en étant élastiquement déformées par le cavalier 20 exerçant une force sur les bras de contact A120a, A120b vers les premières bornes de connexion 120a, 120b et en ce que lors du déplacement de la position initiale à la position déconnectée, le cavalier 20 libère chaque bras de contact A120a, A120b qui revient dans leur forme initiale avant déformation élastique en s'écartant chacun de la première borne de connexion 120a, 120b correspondante.

En l'occurrence, dans cette mise en oeuvre de ce mode de réalisation le cavalier 20 comprend un écarteur 212 agencé en position initiale pour écarter les bras de contact A120a, A120b vers les premières bornes de connexion 120a, 120b. L'écarteur 212 peut être conductible électriquement. L'écarteur 212 comprend en l'occurrence des bras d'écarteur 212a, 212b pour écarter chaque bras de contact A120a, A120b vers les premières bornes de connexion 120a, 120b.

L'écarteur 212 a en l'occurrence une forme de trapèze dont les bras d'écarteurs 212a ,212b sont inclinées pour faciliter le montage de l'écarteur entre les deux bras de contact A120a, A120b mais pourrait être inversé pour faciliter le déplacement du cavalier 20 de la position initiale vers la position déconnectée. L'écarteur 212 de cet exemple se déforme élastiquement lors du déplacement du cavalier 20 de la position initiale vers la position déconnectée pour libérer les deux bras de contact A120a, A120b. La force exercée par le moyen élastique 21 sur le cavalier 20 permet de déformer ces bras d'écarteurs 212a, 212b de l'écarteur 212.

En outre, dans cet exemple, le cavalier 20 comprend un premier et un deuxième écran 213a, 213b agencés pour être, dans la position déconnectée, chacun situé entre respectivement le premier, deuxième bras de contact A120a, A120b et les premières bornes de connexion 120a, 120b.

Le premier et le deuxième écran 213a et 213b sont en matière isolante électriquement permettant ainsi d'isoler électriquement (même en cas d'arc électrique) le premier, deuxième bras de contact A120a, A120b des premières bornes de connexion 120a, 120b.

Le cavalier 20 comprend un espace entre le premier et le deuxième écran 213a et 213b pour recevoir les bras de contact A120a, A120b en position déconnectée.

Dans cette mise en oeuvre, le premier et le deuxième écran 213a et 213b comprend un biseau a son extrémité pouvant permettre d'aider à s'insérer entre respectivement le premier, deuxième bras de contact A120a, A120b et les premières bornes de connexion 120a, 120b lors du déplacement de la position initiale à la position déconnectée du cavalier 20, notamment en cas d'arc électrique exerçant une force de retenu sur les bras de contact A120a, A120b vers la position connectée.

En position déconnectée, dans cet exemple, le premier et le deuxième écran 213a et 213b comprennent chacun une portion le long de la première borne de connexion 120a, 120b correspondant permettant ainsi de guider le cavalier 20 lors de son déplacement.

Selon un autre exemple non représenté, le moyen élastique 21 a des propriétés élastiques pour qu'en position de déconnexion la force exercée par le moyen élastique permettant au cavalier 20 de déformer les bras de contact A120a, A120b pour les écarter chacun de la première borne de connexion 120a, 120b correspondante. Dans ce cas soit les bras de contact A120a, A120b peuvent être montés déformés élastiquement tel qu'elle exerce une force vers les bornes de connexion 120a, 120b et le cavalier 20 peut ainsi être dépourvu d'écarteur. Cependant dans cet exemple, le moyen élastique 21 doit avoir une force plus importante que dans l'exemple représenté.

En l'occurrence, le moyen élastique comprend deux ressorts 210, 211 montés de façon coaxiale entre la paroi d'appui et le cavalier 20.

Le boîtier 3 comprend dans cet exemple un cache 32 comprenant la paroi d'appui du moyen élastique. Le cache 32 est monté amovible sur le boitier 3 en l'occurrence monté par clipsage dans une fenêtre d'une paroi du couvercle 31. Le clipse est visible notamment sur la figure 2d. Le boitier 3 comprend en outre une manette 35 pivotante par rapport au couvercle 31 permettant d'avoir accès au cache 32. En outre cette manette 35 peut permettre à l'installateur de retirer la cassette pour faciliter le changement de la cassette C.

Ainsi, il est possible d'insérer le dispositif de varistances à détection d'emballement thermique 1, et remonter le cavalier 20 dans sa position initiale avant insertion du moyen élastique dans le logement A1 du boîtier 3. Cela permet ainsi de pouvoir retirer un dispositif de varistances à détection d'emballement thermique 1 ayant un scellement descellé dû à une température de la patte de protection thermique de l'ensemble de varistances ayant atteint la température prédéterminée de sécurité.

Dans cet exemple de ce mode de réalisation, le cavalier 20 comprend un verrou rotatif 200 comprenant les deux butées en appui sur les deux pattes de retenu 121a, 121b en position initiale et un séparateur isolant 201 sur lequel est monté le verrou rotatif 200. Le séparateur isolant 201 comprend en l'occurrence les premier et deuxième écrans 213a, 213b. Le séparateur isolant 201 comprend un logement comprenant le moyen de rappel 21 comprimé en position initiale. Ainsi cela permet d'isoler le moyen de rappel afin d'éviter que des arcs électriques se produisent avec celui-ci.

Les deux buttées du verrou rotatif 200 sont situées à l'opposée l'une de l'autre et le moyen élastique exerce une force sur une zone du cavalier entre ces deux butées. En l'occurrence le moyen élastique 21 exerce une force sur le séparateur isolant 201 qui comprend un axe de pivotement 2010 (référencé sur les figures 1 et 3B) et en ce que le verrou rotatif 200 comprend une ouverture dans laquelle est insérée l'axe de pivotement 2010.

L'ouverture du verrou rotatif 200 et l'axe de pivotement 2010 permet, en position initiale, au verrou rotatif 200 de retenir le séparateur isolant 201 et permet le déplacement du cavalier 20 de sa position initiale vers la position déconnectée en pivotant le verrou rotatif 200 par rapport à l'axe de pivotement 2010 lorsqu'une butée 200a, 200b du verrou rotatif 200 est libérée par le descellement de la patte de retenue 101a, 101b de la première varistance 1a ou de la deuxième varistance 1b.

Ainsi, lorsqu'une des deux pattes de retenu 101a, 101b se descelle de la patte de déconnexion thermique 121a, 121b correspondant, elle tombe et ne retient plus le verrou rotatif 200 qui tourne par rapport au séparateur isolant 201 du fait qu'il ne comporte qu'une butée en appuie sur l'autre pattes de retenu 101b, 101a scellée.

Les figures 3A et 3B représentent une vue en perspective d'une partie du parasurtenseur P dans la position déconnectée.

Dans ces figures, on peut voir que la première patte de retenu 101a est descellée de la première patte de déconnexion thermique 121a et le moyen de rappel 21 est mi-contraint ou détendu, le verrou rotatif 200 ayant pivoté angulairement n'est plus en buté contre les pattes de retenue 101a, 101b. Le séparateur isolant 201 est donc en position déconnectée en ayant son premier écran 213a situé entre le premier bras de contact A120a et la première borne de connexion 120a de la première varistance 1a ainsi que son deuxième écran 213b situé entre le deuxième bras de contact A120b et la première borne de connexion 120b de la deuxième varistance 1b.

Le parasurtenseur comprend en outre un socle S présentant, à sa base, une semelle de fixation S1 adaptée à en permettre la fixation sur un rail du type dit en chapeau.

Le socle S formé, dans la forme de cet exemple de ce mode de réalisation représentée, comprend deux coquilles S11, S11' convenablement affrontées l'une à l'autre et convenablement liées l'une à l'autre par un moyen de fixation tel que des vis ou des rivets.

Le socle S comprend en outre une première et une deuxième borne de raccordement de phase S2, S3 pour être chacune raccordée au réseau ou à la terre et en outre être connectée respectivement avec la première borne de liaison électrique A12 et la deuxième borne de liaison électrique A13 par exemple par enfichage. Ainsi il est possible de rendre amovible la cassette C pour la remplacer par une autre cassette C en cas d'un ensemble de varistances 1 déconnectée.

L'appareil électrique contre les surtensions transitoires A comprend en outre dans cet exemple de ce mode de réalisation un indicateur d'états 6 de l'ensemble de varistances, monté solidaire du cavalier 20, en l'occurrence clipsé sur le séparateur isolant 201. L'indicateur d'états 6 comprend deux marques d'indications d'états, une marque d'état de marche, par exemple une marque verte et une marque d'état hors service, par exemple une marque rouge. Le boîtier 3 comprend une fenêtre d'identification 36 pour permettre à l'utilisateur de voir une des deux marques de l'indicateur d'état 6. Ainsi à l'état initial, la fenêtre d'identification 36 est située en vis-à-vis de la marque d'état de marche et en position déconnectée, le cavalier 20 s'étant déplacer, l'indicateur d'états 6 a sa marque d'état hors service en vis-à-vis de la fenêtre d'identification 36. L'appareil électrique contre les surtensions transitoires A peut comprend un cache de protection A6 avant installation permettant de protéger le dispositif de protection thermique 2 contre des intrusions d'éléments externe par la fenêtre d'identification 36.

Sauf précision contraire, un même élément apparaissant sur des figures différentes présente une référence unique.

## Revendications

1. Appareil électrique contre les surtensions transitoires (A) comprenant :
- un logement (A1) destiné à recevoir un dispositif de varistances à détection d'emballement thermique (1) comprenant au moins un ensemble de varistances(1 ab), un premier détecteur thermique (10a) d'une varistance (1a) et un deuxième détecteur thermique (10b) d'une autre varistance (1b) comprenant chacun un scellement à déconnexion thermique se descellant au-delà d'une température prédéterminée de sécurité,
- une première borne de liaison électrique (A12) destinée à être reliée indépendamment à un réseau d'alimentation ou à la terre, s'étendant en outre dans le logement pour être connectée à l'ensemble de varistances (1 ab), et
- un dispositif de protection thermique (2) comprenant :
∘une première zone de déclenchement (200a) destinée à se déclencher lorsque le scellement du premier détecteur thermique (10a) se descelle,
∘une deuxième zone de déclenchement (200b) différente de la première zone de déclenchement (200a), destinée à se déclencher lorsque le scellement du deuxième détecteur thermique (10b) se descelle,
le dispositif de protection thermique (2) étant agencé pour que si la première zone ou la deuxième zone se déclenche (200a, 200b), le dispositif thermique (2) déconnecte électriquement l'ensemble de varistances (1 ab) de la première borne de liaison électrique (A12).

2. Appareil électrique contre les surtensions transitoires (A) selon la revendication précédente, dans lequel :
- la première borne de liaison électrique (A12) est mobile entre une position initiale dans laquelle elle est adaptée à être en contact avec une première borne de connexion (120a, 120b) de l'ensemble varistance, et une position déconnectée dans laquelle la première borne de liaison électrique est adaptée à être éloignée de la première borne de connexion (120a, 120b) de l'ensemble varistance pour déconnecter électriquement l'ensemble de varistances de la première borne de liaison électrique, et
- la première borne de liaison électrique (A12) est séparée et éloignée de la première et de la deuxième zone de déclenchement et le dispositif de protection thermique permet l'ouverture du contact d'alimentation pour déconnecter les varistances de la première borne de liaison.

3. Appareil électrique contre les surtensions transitoires (A) selon la revendication 1 ou 2, dans lequel la première borne de liaison électrique (A12) comprend une épingle comprenant une partie centrale destinée à être reliée à une première borne de raccordement de phase (S2) pour être reliée au réseau ou à la terre et un bras de contact mobile (A120a, A120b) par varistance, (1a, 1b) destiné à être en contact chacun avec une borne de connexion (120a, 120b) de la varistance (1a, 1b) correspondante en position connectée et éloignée chacun de la borne de connexion de la varistance (1a, 1b) correspondante en position déconnectée.

4. Appareil électrique contre les surtensions transitoires (A) selon la revendication précédente, dans lequel chaque bras de contact mobile (A120a, A120b) est déformé élastiquement par le dispositif de protection thermique (2) en position initiale et en ce que le déplacement du dispositif de protection (2) thermique, en position déconnectée, libère chaque bras de contact mobile (A120a, A120b) qui revient dans sa forme initiale dans la position déconnectée.

5. Dispositif de varistances à détection d'emballement thermique (1) pour un appareil électrique contre les surtensions transitoires (A) selon l'une des revendications 1 à 4, le dispositif de varistance à détection d'emballement thermique (1) comprenant :
- un ensemble de varistances (1 ab) comprenant :
o au moins une première borne de connexion (120a ,120b) destinée à être connectée à la première borne de liaison électrique de l'appareil électrique contre les surtensions transitoires (A) pour relier l'ensemble de varistances au réseau ou la terre de l'installation et
o une première et deuxième varistance (1a, 1b) comprenant chacune indépendamment une patte de déconnexion thermique (121a, 121b)
o la première borne de connexion (120a, 120b) étant distinct des pattes de déconnexion thermique (121a, 121b),
- un premier détecteur thermique (10a) et un deuxième détecteur thermique (10b) comprenant chacun un scellement fixé à respectivement la patte à déconnexion thermique (121a, 121b) de la première et deuxième varistance (1a, 1b) se descellant au-delà d'une température prédéterminée de sécurité.

6. Dispositif de varistances à détection d'emballement thermique (1) selon la revendication précédente, dans lequel l'ensemble de varistances (1ab) comprend par varistance une première plaque de contact (12a, 12b) conductrice électriquement comprenant la patte de déconnexion thermique (121a, 121b) et la première borne de connexion (120a, 120b) de façon distincte l'une de l'autre.

7. Dispositif de varistances à détection d'emballement thermique (1) selon la revendication précédente, dans lequel l'ensemble de varistances (1ab) est une varistance double comprenant :
- un bloc de céramique (11) par varistance,
- une plaque de contact centrale (13) entre les deux blocs de céramique,
- dans lequel la première plaque de contact est une plaque de contact latérale (12) contiguë avec un des deux blocs à l'opposé de la plaque de contact centrale, et la deuxième plaque de contact latérale (12) comprenant la patte de déconnexion thermique (121a, 121b) est contigüe avec l'autre bloc.

8. Dispositif de varistances à détection d'emballement thermique (1) selon la revendication précédente, dans lequel le premier détecteur thermique (10a) et le deuxième détecteur thermique (10b) comprennent en outre chacun respectivement une première et une deuxième patte de retenu (101a, 101b) scellées chacune respectivement à la patte de déconnexion thermique (121a, 121b) de la première et deuxième varistance (1a, 1b) pour se desceller à partir d'une température prédéterminée de sécurité.

9. Cassette d'un parasurtenseur comprenant un appareil électrique contre les surtensions transitoires (A) selon l'une des revendication 1 à 4 et un dispositif de varistances à détection d'emballement thermique (1) selon l'une des revendications précédentes 5 à 8, monté dans le logement (A1) de l'appareil électrique contre les surtensions transitoires (A), la première borne de liaison électrique (A12) étant en contact électriquement et physiquement avec l'au moins une première borne de connexion (120a, 120b) et en ce que le premier détecteur thermique (10a) et le deuxième détecteur thermique (10b) sont chacun agencé avec respectivement la première zone de déclenchement (200a) et la deuxième zone de déclenchement (200b) pour que le dispositif thermique (2) déconnecte électriquement l'ensemble de varistances (1ab) de la première borne de liaison électrique (A12).

10. Parasurtenseur comprenant un socle (S) et une cassette selon la revendication 9 monté sur le socle (S), le socle S comprenant des bornes de branchement en contact physiquement et électriquement avec les bornes de liaisons pour reliées les bornes de liaisons au réseau électrique.

11. Procédé de déconnexion électrique d'un ensemble de varistances de la cassette (1) selon la revendication 9:
- une étape de déscellement du premier détecteur thermique (10a) d'une varistance (1a) ou du deuxième détecteur thermique (10b) d'une autre varistance (1b) de l'ensemble de varistances (1ab) de respectivement,
- après l'étape de descellement, une étape de déclenchement respectivement de la première zone ou de la deuxième zone de déclenchement du dispositif de protection thermique (2), et
- après l'étape de descellement, une étape de déconnexion électrique de l'ensemble de varistances (1ab) de de la première borne de liaison électrique.

## Patentansprüche

1. Elektrisches Gerät gegen transiente Überspannungen (A) umfassend:
- ein Gehäuse (A1) zur Aufnahme einer Varistoranordnung zur Detektion des thermischen Durchgehens (1), die mindestens einen Satz von Varistoren (1 ab), einen ersten Thermodetektor (10a) eines Varistors (1a) und einen zweiten Thermodetektor (10b) eines anderen Varistors (1b) umfasst, die jeweils eine Versiegelung mit thermischer Trennung umfassen, die sich über eine vorbestimmte Sicherheitstemperatur hinaus herauslöst,
- eine erste elektrische Verbindungsklemme (A12), die dazu bestimmt ist, unabhängig mit einem Stromnetz oder mit der Erdung verbunden zu werden, und die sich außerdem in das Gehäuse erstreckt, um mit der Varistoranordnung (1ab) verbunden zu werden, und
- eine Wärmeschutzvorrichtung (2) mit:
∘ einem ersten Auslösebereich (200a), der dazu bestimmt ist, auszulösen, wenn sich die Versiegelung des ersten Thermodetektors (10a) herauslöst,
∘ einem zweiten Auslösebereich (200b), der sich vom ersten Auslösebereich (200a) unterscheidet und dazu bestimmt ist, auszulösen, wenn sich die Versiegelung des zweiten Thermodetektors (10b) herauslöst,
wobei die Wärmeschutzvorrichtung (2) so angeordnet ist, dass, wenn der erste Bereich oder der zweite Bereich auslöst (200a, 200b), die Wärmeschutzvorrichtung (2) die Varistoranordnung (1ab) elektrisch von der ersten elektrischen Verbindungsklemme (A12) trennt.

2. Elektrisches Gerät gegen transiente Überspannungen (A) nach dem vorhergehenden Anspruch, in dem:
- die erste elektrische Verbindungsklemme (A12) beweglich ist zwischen einer Ausgangsposition, in der sie dazu geeignet ist, mit einer ersten Anschlussklemme (120a, 120b) der Varistoranordnung in Kontakt zu kommen, und einer getrennten Position, in der die erste elektrische Verbindungsklemme dazu geeignet ist, von der ersten Anschlussklemme (120a, 120b) der Varistoranordnung entfernt zu werden, um die Varistoranordnung von der ersten elektrischen Verbindungsklemme elektrisch zu trennen, und
- die erste elektrische Verbindungsklemme (A 12) vom ersten und zweiten Auslösebereich getrennt und entfernt ist und die thermische Schutzvorrichtung das Öffnen des Versorgungskontakts ermöglicht, um die Varistoren von der ersten Verbindungsklemme zu trennen.

3. Elektrisches Gerät gegen transiente Überspannungen (A) nach Anspruch 1 oder 2, in dem die erste elektrische Verbindungsklemme (A12) einen Pin umfasst, der ein Mittelteil zur Verbindung mit einem ersten Phasenanschluss (S2) zur Verbindung mit dem Stromnetz oder mit der Erdung und einen beweglichen Kontaktarm (A120a, A 120b) pro Varistor (1a, 1b) umfasst, der dazu bestimmt ist, in der verbundenen Position jeweils mit einer Anschlussklemme (120a, 120b) des entsprechenden Varistors (1a, 1b) in Kontakt zu stehen und in der getrennten Position jeweils von der Verbindungsklemme des entsprechenden Varistors (1a, 1b) entfernt zu sein.

4. Elektrisches Gerät gegen transiente Überspannungen (A) nach dem vorhergehenden Anspruch, in dem jeder bewegliche Kontaktarm (A120a, A 120b) durch die thermische Schutzvorrichtung (2) in die Ausgangsposition elastisch verformt wird, und in dem die Bewegung der thermischen Schutzvorrichtung (2) in die getrennte Position jeden beweglichen Kontaktarm (A120a, A 120b) freigibt, der in der getrennten Position in seine ursprüngliche Form zurückkehrt.

5. Varistoranordnung (1) mit Detektion des thermischen Durchgehens für ein elektrisches Gerät gegen transiente Überspannungen (A) nach einem der Ansprüche 1 bis 4, wobei die Varistoranordnung (1) mit Detektion des thermischen Durchgehens umfasst:
- eine Anordnung von Varistoren (1ab) mit:
∘ mindestens einer ersten Anschlussklemme (120a, 120b), die dazu bestimmt ist, mit der ersten elektrischen Verbindungsklemme des elektrischen Geräts gegen transiente Überspannungen (A) verbunden zu werden, um die Varistoranordnung mit dem Stromnetz oder der Erdung der Anlage zu verbinden, und
∘ einem ersten und einem zweiten Varistor (1a, 1b), die jeweils unabhängig voneinander eine thermische Trennungslasche (121a, 121b) umfassen
∘ wobei die erste Anschlussklemme (120a, 120b) von den thermischen Trennungslaschen (121a, 121b) getrennt ist,
- einen ersten Thermodetektor (10a) und einen zweiten Thermodetektor (10b), die jeweils eine Versiegelung umfassen, die jeweils an der thermischen Trennungslasche (121a, 121b) des ersten und zweiten Varistors (1a, 1b) befestigt ist, die sich über eine vorbestimmte Sicherheitstemperatur hinaus herauslösen.

6. Varistoranordnung zur Detektion des thermischen Durchgehens (1) nach dem vorhergehenden Anspruch, in der die Varistoranordnung (1ab) pro Varistor eine erste elektrisch leitende Kontaktplatte (12a, 12b) umfasst, die die thermische Trennungslasche (121a, 121b) und die erste Anschlussklemme (120a, 120b) getrennt voneinander umfasst.

7. Varistoranordnung zur Detektion eines thermischen Durchgehens (1) nach dem vorhergehenden Anspruch, in der die Varistoranordnung (1ab) ein Doppelvaristor ist, der Folgendes umfasst:
- einen Keramikblock (11) pro Varistor,
- eine mittlere Kontaktplatte (13) zwischen den beiden Keramikblöcken,
- wobei die erste Kontaktplatte eine seitliche Kontaktplatte (12) ist, die an einen der beiden Blöcke gegenüber der mittleren Kontaktplatte angrenzt, und die zweite seitliche Kontaktplatte (12), die die thermische Trennungslasche (121a, 121b) umfasst, an den anderen Block angrenzt.

8. Varistoranordnung (1) zur Detektion eines thermischen Durchgehens nach dem vorhergehenden Anspruch, in der der erste Thermodetektor (10a) und der zweite Thermodetektor (10b) außerdem jeweils eine erste und eine zweite Rückhaltelasche (101a, 101b) umfassen, die jeweils an der thermischen Trennlasche (121a, 121b) des ersten und zweiten Varistors (1a, 1b) versiegelt sind, um sich ab einer vorbestimmten Sicherheitstemperatur herauszulösen.

9. Kassette eines Überspannungsableiters, umfassend ein elektrisches Gerät gegen transiente Überspannungen (A) nach einem der Ansprüche 1 bis 4 und eine Varistoranordnung mit Detektion des thermischen Durchgehens (1) nach einem der vorhergehenden Ansprüche 5 bis 8, die im Gehäuse (A 1) des elektrischen Geräts gegen transiente Überspannungen (A) montiert ist, wobei die erste elektrische Verbindungsklemme (A12) in elektrischem und physischem Kontakt mit der mindestens einen ersten Anschlussklemme (120a, 120b) verbunden ist, und der erste Thermodetektor (10a) und der zweite Thermodetektor (10b) jeweils mit dem ersten Auslösebereich (200a) bzw dem zweiten Auslösebereich (200b) so angeordnet sind, dass die Wärmeschutzvorrichtung (2) die Varistoranordnung (1ab) elektrisch von der ersten elektrischen Verbindungsklemme (A12) trennt.

10. Überspannungsableiter mit einem Sockel (S) und einer Kassette nach Anspruch 9, die auf dem Sockel (S) montiert ist, wobei der Sockel S Anschlussklemmen umfasst, die in physischem und elektrischem Kontakt mit den Verbindungsklemmen stehen, um die Verbindungsklemmen mit dem Stromnetz zu verbinden.

11. Verfahren zum elektrischen Trennen einer Varistoranordnung von der Kassette (1) nach Anspruch 9, umfassend:
- einen Schritt zum Herauslösen des ersten Thermodetektors (10a) aus einem Varistor (1a) oder des zweiten Thermodetektors (10b) aus einem anderen Varistor (1b) der Varistoranordnung (1ab),
- nach dem Schritt des Herauslösens, einen Schritt des Auslösens des ersten bzw. des zweiten Auslösebereichs der Wärmeschutzvorrichtung (2) und
- nach dem Schritt des Herauslösens, einen Schritt des elektrischen Trennens der Varistoranordnung (1ab) von der ersten elektrischen Verbindungsklemme.

## Claims

1. Electrical device against transient overvoltages (A) comprising:
- a housing (A1) intended to receive a varistor device for detecting thermal runaway (1) comprising at least one set of varistors (1ab), a first thermal detector (10a) of a varistor (1a) and a second thermal detector (10b) of another varistor (1b) each comprising a sealing with thermal disconnection that unseals beyond a predetermined safety temperature,
- a first electrical junction terminal (A12) intended to be independently connected to a power grid or to the ground, extending furthermore in the housing to be connected to the set of varistors (1ab), and
- a thermal protection device (2) comprising:
o a first trip zone (200a) intended to be tripped when the sealing of the first thermal detector (10a) is unsealed,
o a second trip zone (200b) different from the first trip zone (200a), intended to be tripped when the sealing of the second thermal detector (10b) is unsealed,
the thermal protection device (2) being arranged so that if the first zone or the second zone is tripped (200a, 200b), the thermal device (2) electrically disconnects the set of varistors (1ab) from the first electrical junction terminal (A12).

2. Electrical device against transient overvoltages (A) according to the preceding claim, wherein:
- the first electrical junction terminal (A12) can be moved between an initial position wherein it is adapted to be in contact with a first connecting terminal (120a, 120b) of the varistor set, and a disconnected position wherein the first electrical junction terminal is adapted to be moved away from the first connecting terminal (120a, 120b) of the varistor set in order to electrically disconnect the set of varistors from the first electrical junction terminal, and
- the first electrical junction terminal (A12) is separated and moved away from the first and the second trip zone, and the thermal protection device allows the opening of the power contact to disconnect the varistors from the first junction terminal.

3. Electrical device against transient overvoltages (A) according to claim 1 or 2, wherein the first electrical junction terminal (A12) comprises a pin comprising a central portion intended to be connected to a first phase connection terminal (S2) to be connected to the grid or to the ground and a movable contact arm (A120a, A120b) per varistor, (1a, 1b) intended to each be in contact with a connecting terminal (120a, 120b) of the corresponding varistor (1a, 1b) in the connected position and each moved away from the connecting terminal of the corresponding varistor (1a, 1b) in disconnected position.

4. Electrical device against transient overvoltages (A) according to the preceding claim, wherein each movable contact arm (A120a, A120b) is elastically deformed by the thermal protection device (2) in the initial position and in that the displacement of the thermal protection device (2), in the disconnected position, releases each movable contact arm (A120a, A120b) which returns to its initial shape in the disconnected position.

5. Varistor device for detecting thermal runaway (1) for an electrical device against transient overvoltages (A) according to one of claims 1 to 4, the varistor device for detecting thermal runaway (1) comprising:
- a set of varistors (1ab) comprising:
∘at least one first connecting terminal (120a,120b) intended to be connected to the first electrical junction terminal of the electrical device against transient overvoltages (A) in order to connect the set of varistors to the grid or the ground of the installation and
∘a first and second varistor (1a, 1b) each independently comprising a thermal disconnection tab (121a, 121b)
∘the first connecting terminal (120a, 120b) being separate from the thermal disconnection tabs (121a, 121b),
- a first thermal detector (10a) and a second thermal detector (10b) each comprising a sealing fastened respectively to the thermal disconnection tab (121a, 121b) of the first and second varistor (1a, 1b) that unseals beyond a predetermined safety temperature.

6. Varistor device for detecting thermal runaway (1) according to the preceding claim, wherein the set of varistors (1ab) comprises per varistor a first electrically conductive contact plate (12a, 12b) comprising the thermal disconnection tab (121a, 121b) and the first connecting terminal (120a, 120b) separately from one another.

7. Varistor device for detecting thermal runaway (1) according to the preceding claim, wherein the set of varistors (1ab) is a double varistor comprising:
- a ceramic block (11) per varistor,
- a central contact plate (13) between the two ceramic blocks,
- wherein the first contact plate is a side contact plate (12) contiguous with one of the two blocks opposite the central contact plate, and the second side contact plate (12) comprising the thermal disconnection tab (121a, 121b) is contiguous with the other block.

8. Varistor device for detecting thermal runaway (1) according to the preceding claim, wherein the first thermal detector (10a) and the second thermal detector (10b) each further comprise respectively a first and a second retaining tab (101a, 101b) each sealed respectively to the thermal disconnection tab (121a, 121b) of the first and second varistor (1a, 1b) in order to be unsealed starting from a predetermined safety temperature.

9. Cassette of an arrester comprising an electrical device against transient overvoltages (A) according to one of claims 1 to 4 and Varistor device for detecting thermal runaway (1) according to one of the preceding claims 5 to 8, mounted in the housing (A1) of the electrical device against transient overvoltages (A), the first electrical junction terminal (A12) being in contact electrically and physically with the at least one first connecting terminal (120a, 120b) and in that the first thermal detector (10a) and the second thermal detector (10b) are each arranged with respectively the first trip zone (200a) and the second trip zone (200b) so that the thermal device (2) electrically disconnects the set of varistors (1ab) from the first electrical junction terminal (A12).

10. Arrester comprising a cradle (S) and a cassette according to the claim 9 mounted on the cradle (S), the cradle S comprising connector terminals in contact physically and electrically with the junction terminals to connect the junction terminals to the electrical grid.

11. Method for the electrical disconnection from a set of varistors of the cassette (1) according the claim 9:
- a step of unsealing of the first thermal detector (10a) of a varistor (1a) or of the second thermal detector (10b) of another varistor (1b) from the set of varistors (1ab) respectively,
- after the step of unsealing, a step of tripping respectively the first zone or the second trip zone of the thermal protection device (2), and
- after the step of unsealing, a step of electrically disconnecting the set of varistors (1ab) from the first electrical junction terminal.
